# EUROPEAN PATENT SPECIFICATION

(11) **EP 2 744 107 B1**
(45) Date of publication and mention of the grant of the patent: **15.01.2020**
(21) Application number: 12822720.4
(22) Date of filing: 03.08.2012
(51) Int. Cl.: H03H 9/02

(54) **ELASTIC WAVE DEVICE**
ELASTISCHE WELLENVORRICHTUNG
DISPOSITIF À ONDE ÉLASTIQUE

(30) Priority: 08.08.2011 JP 2011173120
(43) Date of publication of application: 18.06.2014
(73) Proprietor: Murata Manufacturing Co., Ltd., Nagaokakyo-shi, Kyoto 617-8555 (JP)
(72) Inventor: KADOTA, Michio, Nagaokakyo-shi Kyoto 617-8555 (JP)
(74) Representative: Cabinet Beau de Loménie
(86) International application number: PCT/JP2012/069865
(87) International publication number: WO 2013/021948

(56) References cited:
- EP-A2- 1 821 406
- WO-A1-2007/046236
- WO-A1-2010/004741
- WO-A1-2010/082571
- JP-A- 2002 152 007
- JP-A- 2010 056 736
- US-A- 5 532 538
- VOHRA G ET AL: "High frequency shear horizontal plate acoustic wave devices", ULTRASONICS, IPC SCIENCE AND TECHNOLOGY PRESS LTD. GUILDFORD, GB, vol. 49, no. 8, 1 December 2009 (2009-12-01), pages 760-764, XP026740454, ISSN: 0041-624X, DOI: 10.1016/J.ULTRAS.2009.05.011 [retrieved on 2009-06-09]
- ZAITSEV B D ET AL: "Investigation of quasi-shear-horizontal acoustic waves in thin plates of lithium niobate", SMART MATERIALS AND STRUCTURES, IOP PUBLISHING LTD., BRISTOL, GB, vol. 6, no. 6, 1 December 1997 (1997-12-01), pages 739-744, XP020071954, ISSN: 0964-1726, DOI: 10.1088/0964-1726/6/6/011
- JOSHI S G ET AL: "Characteristics of fundamental acoustic wave modes in thin piezoelectric plates", ULTRASONICS, IPC SCIENCE AND TECHNOLOGY PRESS LTD. GUILDFORD, GB, vol. 44, 22 December 2006 (2006-12-22), pages e787-e791, XP025009279, ISSN: 0041-624X, DOI: 10.1016/J.ULTRAS.2006.05.013 [retrieved on 2006-12-22]
- TODA K ET AL: "SUBSTRATE THICKNESS DEPENDENCE OF SH WAVE PROPAGATION CHARACTERISTICS IN ROTATED Y-CUT X-PROPAGATION LINBO3", THE JOURNAL OF THE ACOUSTICAL SOCIETY OF AMERICA, AMERICAN INSTITUTE OF PHYSICS FOR THE ACOUSTICAL SOCIETY OF AMERICA, NEW YORK, NY, US, vol. 79, no. 1, 1 January 1986 (1986-01-01), pages 160-163, XP002019063, ISSN: 0001-4966, DOI: 10.1121/1.393640
- LAURENT T ET AL: "LAMB AND SHEAR-HORIZONTAL WAVE PRODUCTION BY INTERDIGITAL TRANSDUCERS DEPOSITED ON BOTH SIDES OF A PIEZOELECTRIC PLATE", THE JOURNAL OF THE ACOUSTICAL SOCIETY OF AMERICA, AMERICAN INSTITUTE OF PHYSICS FOR THE ACOUSTICAL SOCIETY OF AMERICA, NEW YORK, NY, US, vol. 99, no. 5, 1 May 1996 (1996-05-01), pages 2876-2882, XP000621084, ISSN: 0001-4966, DOI: 10.1121/1.414819
- KUZNETSOVA I E ET AL: "Investigation of acoustic waves in thin plates of lithium niobate and lithium tantalate", IEEE TRANSACTIONS ON ULTRASONICS, FERROELECTRICS AND FREQUENCY CONTROL, IEEE, US, vol. 48, no. 1, 1 January 2001 (2001-01-01), pages 322-328, XP011435234, ISSN: 0885-3010, DOI: 10.1109/58.896145

## Description

### Technical Field

The present invention relates to elastic wave devices used as resonators or band-pass filters and particularly relates to an elastic wave device making use of a shear-horizontal (SH) plate wave propagating in LiNbO₃ substrates.

### Background Art

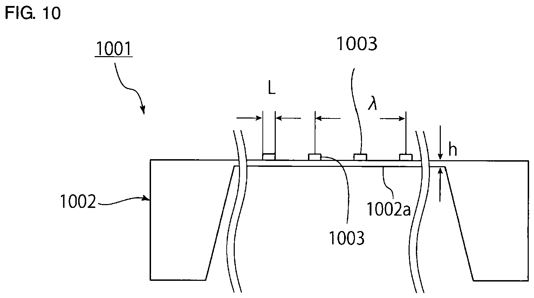

Hitherto, various elastic wave devices making use of a plate wave propagating in LiNbO₃ have been proposed. For example, Patent Document 1 below discloses an elastic wave resonator shown in Fig. 10. The elastic wave resonator 1001 includes a LiNbO₃ single-crystalline substrate 1002 as shown in Fig. 10. The center of the LiNbO₃ single-crystalline substrate 1002 is a thin plate portion 1002a. That is, a central portion of the LiNbO₃ single-crystalline substrate 1002 is thin and has a thickness h. In an example described in Patent Document 1, the thickness h is 0.03λ₀.

The upper surface of the thin plate portion 1002a is overlaid with IDT electrodes 1003. Supposing the pitch between electrode fingers of the IDT electrodes 1003 is λ₀, the width L of the electrode fingers is 0.125λ₀.

Patent Document 1 describes that when the orientation of LiNbO₃ is rotated about the X-axis at an angle of -10° to 70° in a direction from the Y-axis to the Z-axis, a major component of elastic vibration is an SH wave and a piezoelectric effect is large.

In the example described in Patent Document 1, the IDT electrodes 1003 are made of an AI-0.7% Cu alloy. On the other hand, the LiNbO₃ single-crystalline substrate 1002 is a 40° Y substrate. This means that θ of Euler angles (ϕ, θ, ψ) is equal to 130°.

On the other hand, paragraph [0051] of Patent Document 2 below discloses an elastic wave element containing LiNbO₃ with a rotation angle of 36° ± 20°, that is, LiNbO₃ with Euler angles (0°, 106° to 146°, 0°). Herein, an elastic wave-propagating surface of a piezoelectric substrate made of LiNbO₃ is mechanically free and the thickness of the piezoelectric substrate made of LiNbO₃ is less than the wavelength λ of an elastic wave.

### Citation List

### Patent Document

Patent Document 1: Japanese Unexamined Patent Application Publication No. 2002-152007
Patent Document 2: Japanese Unexamined Patent Application Publication No. 2002-368576

The paper "High frequency shear horizontal plate acoustic wave devices" by Vohra et al (from Ultrasonics, IPC Science and Technology Press Ltd., GB, Vol.48, no.8, pages 760-764, 1 December 2009) describes obtaining good electromechanical coupling coefficients for SH plate waves in thin LiNbO₃ substrates having Euler angles (0°,90°,0°), in dependence on the product of substrate thickness and operating frequency.

The paper "Investigation of quasi-shear-horizontal acoustic waves in thin plates of lithium niobate" by Zaitsev et al (from Smart Materials and Structures, IOP Publishing Ltd., GB, Vol.6, no.6, pages 739-744, 1 December 1997) likewise describes obtaining good electromechanical coupling coefficients K² for SH plate waves in thin LiNbO₃ substrates and shows a peak K² value at a substrate thickness of around 0.06λ.

US 5 532 538 describes obtaining K² values greater than 0.15 using a substrate that is an elastic material (e.g. Z-cut LiNbO₃) provided that the substrate is no more than 3λ thick.

The paper "Characteristics of fundamental acoustic wave modes in thin piezoelectric plates" by Joshi et al (from Ultrasonics, IPC Science and Technology Press Ltd., GB, Vol.44, pages e787-e791, 22 December 2006) describes good electromechanical coupling coefficients obtained for SH plate waves propagating in rotated Y-cut, X-propagation thin plates of LiNbO₃.

### Summary of Invention

### Technical Problem

However, Patent Document 1 merely describes that when the orientation of LiNbO₃ is within the above specific range, that is, a range specified in terms of Euler angles (0°, 80° to 160°, 0°), the piezoelectric effect due to the SH plate wave is large. A configuration using the SH plate wave described in Patent Document 1 cannot necessarily achieve a sufficiently large electromechanical coupling coefficient k² and therefore is limited in increasing the fractional bandwidth, or bandwidth ratio. Incidentally, Patent Document 1 does not particularly refer to the thickness of the IDT electrodes.

Patent Document 2 discloses the elastic wave device containing LiNbO₃ with the above Euler angles and a structure having an elastic wave-propagating region which is mechanically free and, however, does not describe any configuration using an SH plate wave.

It is an object of the present invention to provide an elastic wave device which makes use of an SH plate wave propagating in LiNbO₃ substrates, which can effectively increase the electromechanical coupling coefficient k², and which, therefore, can increase the bandwidth ratio.

### Solution to Problem

An elastic wave device according to the present invention makes use of an SH plate wave propagating in LiNbO₃ substrates. The elastic wave device according to the present invention includes a LiNbO₃ substrate, IDT electrodes placed on at least one surface of the LiNbO₃ substrate, and a support on which the LiNbO₃ substrate is placed such that the support is located outside a region provided with the IDT electrodes and supports the LiNbO₃ substrate. In the present invention, θ of the Euler angles (0°, θ, 0°) of the LiNbO₃ substrate ranges from 92° to 138° and the thickness of the LiNbO₃ substrate ranges from 0.05λ to 0.25λ, where λ is a wavelength of the SH plate wave determined by a pitch of electrode fingers of the IDT electrodes.

In the elastic wave device according to the present invention, the IDT electrodes are made of a metal containing one of metals shown in Table 1 below as a major component and have a thickness within a range specified in Table 1 depending on the type of the metal.

**[Table 1]**

| | Thickness of IDT electrode |
|---|---|
| Pt | More than 0 to 0.083λ or less |
| Au | More than 0 to 0.055λ or less |
| Cu | More than 0 to 0.11λ or less |
| Ni | More than 0 to 0.16λ or less |
| Al | More than 0 to 0.135λ or less |

In this case, the fractional bandwidth of an SH plate wave can be adjusted to 25% or more.

In a specific aspect of the elastic wave device according to the present invention, the IDT electrodes made of a metal containing one of metals shown in Table 2 below as a major component have a duty ratio within a range specified in Table 2 depending on the type of the metal. The duty ratio is represented by W/(W+G), where W is the width of the electrode fingers of the IDT electrodes and G is the gap between the electrode fingers.

**[Table 2]**

| | Duty ratio |
|---|---|
| Pt | 0.105 to 0.62 |
| Au | 0.105 to 0.585 |
| Cu | 0.11 to 0.645 |
| Ni | 0.11 to 0.655 |
| Al | 0.115 to 0.63 |

In this case, the fractional bandwidth can be increased to 26% or more.

In another specific aspect of the elastic wave device according to the present invention, the support is a support substrate having a through-hole facing a region provided with the IDT electrodes. As described above, a portion facing the region provided with the IDT electrodes may be the through-hole of the support substrate.

In another specific aspect of the elastic wave device according to the present invention, the IDT electrodes are made of a metal containing a metal having a density between 2.699 × 10³ kg/m³ to 8.93 × 10³ kg/m³ as a major component.

### Advantageous Effects of Invention

In an elastic wave device according to the present invention, θ of the Euler angles of LiNbO₃ is within the above specific range and the thickness of a LiNbO₃ substrate is within the above specific range; hence, the electromechanical coupling coefficient of an SH plate wave can be effectively increased. Therefore, resonators and filters with a large bandwidth ratio can be provided.

### Brief Description of Drawings

[Fig. 1] Fig. 1(a) is a front sectional view of an elastic wave device according to a first embodiment of the present invention and Fig. 1(b) is a schematic plan view illustrating the electrode structure thereof.
[Fig. 2] Fig. 2 is a graph showing the relationship between the thickness of Z-cut LiNbO₃ substrates and the acoustic velocity of X-propagating elastic waves.
[Fig. 3] Fig. 3 is a graph showing the relationship between the thickness of Z-cut LiNbO₃ substrates and the electromechanical coupling coefficient of X-propagating elastic waves.
[Fig. 4] Fig. 4 is a graph showing the relationship between θ of the Euler angles of LiNbO₃ substrates with various thicknesses and the electromechanical coupling coefficient k² of the fundamental mode of SH plate waves.
[Fig. 5] Fig. 5 is a graph showing the relationship between the thickness of LiNbO₃ substrates with Euler angles (0°, 120°, 0°) and the electromechanical coupling coefficient k² of elastic waves.
[Fig. 6] Fig. 6 is a graph showing the relationship between the thickness of IDT electrodes which are placed on LiNbO₃ substrates having a thickness of 0.1λ and Euler angles (0°, 120°, 0°) and which are made of various metals and the fractional bandwidth.
[Fig. 7] Fig. 7 is a graph showing the relationship between the thickness of IDT electrodes which are placed on LiNbO₃ substrates having a thickness of 0.1λ and Euler angles (0°, 120°, 0°) and which are made of various metals and reflection coefficient.
[Fig. 8] Fig. 8 is a graph showing the relationship between the duty ratio of IDT electrodes which are placed on LiNbO₃ substrates having a thickness of 0.1λ and Euler angles (0°, 116° to 118°, 0°) and which are made of various metals and the fractional bandwidth.
[Fig. 9] Fig. 9 is a graph showing the relationship between the duty ratio of IDT electrodes which are placed on LiNbO₃ substrates having a thickness of 0.1λ and Euler angles (0°, 120°, 0°) and which are made of various metals and reflection coefficient.
[Fig. 10] Fig. 10 is a schematic sectional view of an example of a conventional elastic wave resonator.

### Description of Embodiments

Embodiments of the present invention will now be described in detail with reference to the accompanying drawings, whereby the present invention will become apparent.

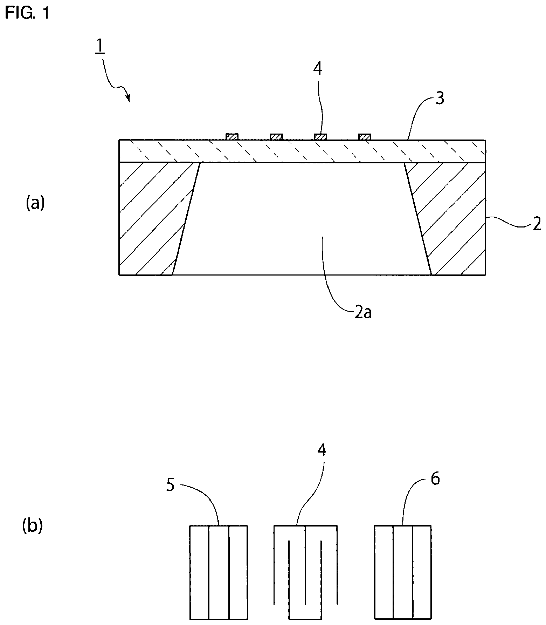

Fig. 1(a) is a front sectional view of an elastic wave device according to a first embodiment of the present invention and Fig. 1(b) is a schematic plan view illustrating the electrode structure of the elastic wave device.

The elastic wave device 1 of this embodiment includes a support 2. The support 2 is made of an appropriate rigid material such as Si, an insulating ceramic, or metal. The support 2 is overlaid with a LiNbO₃ substrate 3. The thickness of the LiNbO₃ substrate 3 ranges from 0.05λ to 0.25λ. The support 2 has a through-hole 2a. In a region facing the through-hole 2a, IDT electrodes 4 are placed on the upper surface of the LiNbO₃ substrate 3.

Fig. 1(a) schematically shows a portion provided with the IDT electrodes 4. In particular, an electrode structure including the IDT electrodes 4 and reflectors 5 and 6 placed on both sides of one of the IDT electrodes 4 is placed as shown in Fig. 1(b). The through-hole 2a is located under the electrode structure. In this embodiment, the presence of the electrode structure provides a one port-type elastic wave resonator.

This embodiment is characterized in that the thickness of the LiNbO₃ substrate 3 ranges from 0.05λ to 0.25λ as described above and θ of the Euler angles (0°, θ, 0°) thereof ranges from 92° to 138°. Incidentally, λ is the wavelength determined by the pitch between electrode fingers of the IDT electrodes 4.

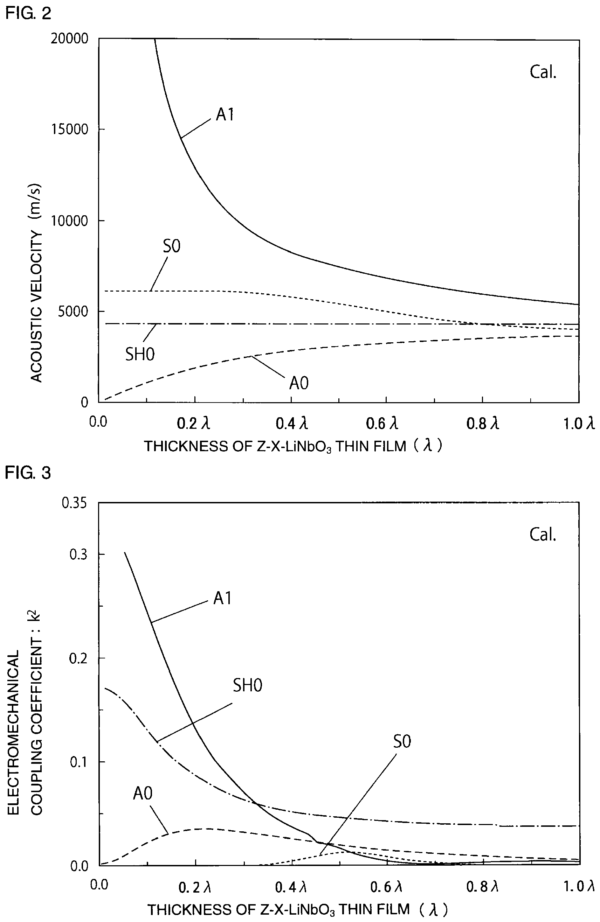

In this embodiment, the presence of the above configuration allows the electromechanical coupling coefficient k² of an SH plate wave to be significantly increased. Thus, resonators and filters with a large bandwidth ratio can be provided. This is described in detail with reference to Figs. 2 to 9.

Fig. 2 is a graph showing Z-X propagation, that is, the relationship between the thickness of LiNbO₃ substrates with Euler angles (0°, 0°, 0°) and the acoustic velocity of elastic waves propagating in the LiNbO₃. Incidentally, SH0 represents the fundamental mode of a SH plate wave and A0, A1, and SO represent modes of Lamb waves. As is clear from Fig. 2, the acoustic velocity of the SH plate wave SH0 varies very little when the thickness of LiNbO₃ widely ranges from 0 to 1.0λ.

Fig. 3 shows the relationship between the thickness of LiNbO₃ substrates with Euler angles (0°, 0°, 0°) and the electromechanical coupling coefficient k² of elastic waves. As is clear from Fig. 3, when the thickness of the LiNbO₃ substrates is small, the electromechanical coupling coefficient k² of an SH plate wave SH0 is large. In particular, when the thickness of the LiNbO₃ is 0.2λ or less, the electromechanical coupling coefficient k² can be increased to 0.08 or more. In the case of 0.2λ or less, the electromechanical coupling coefficient k² sharply increases with a reduction in thickness.

As described above, it is clear that when the thickness of the LiNbO₃ is small, the change in acoustic velocity of the SH plate wave is small and the electromechanical coupling coefficient k² can be increased.

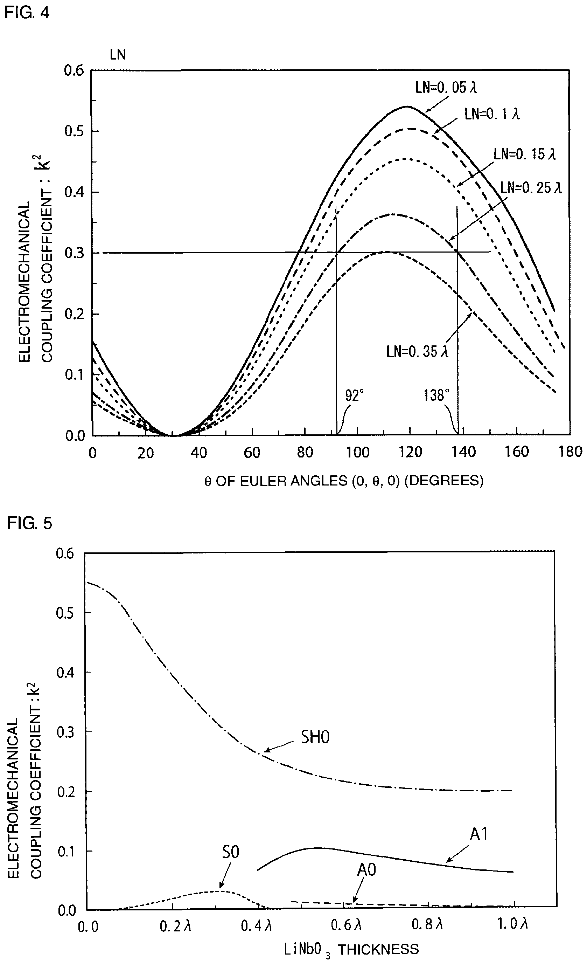

Fig. 4 shows the change in electromechanical coupling coefficient k² of an SH plate wave SH0 in the case where the thickness of LiNbO₃ is 0.05λ, 0.1λ, 0.15λ, 0.25λ, or 0.35λ and θ of the Euler angles (0°, θ, 0°) of each LiNbO₃ substrate is varied. As is clear from Fig. 4, when the thickness of LiNbO₃ ranges from 0.05λ to 0.25λ and θ of the Euler angles ranges from 92° to 138°, the electromechanical coupling coefficient k² of the SH plate wave SH0 is large, 0.30 or more. It is preferred that θ ranges from 105° to 132°, because the electromechanical coupling coefficient k² can be increased to 0.33 or more. Thus, in order to increase the electromechanical coupling coefficient k² of the SH plate wave propagating in LiNbO₃, θ of the Euler angles of LiNbO₃ needs to range from 92° to 138° and preferably ranges from 105° to 132°.

On the other hand, Fig. 5 is a graph showing the relationship between the thickness of LiNbO₃ substrates with Euler angles (0°, 120°, 0°) and the electromechanical coupling coefficient k². As is clear from Fig. 5, when the Euler angles are (0°, 120°, 0°) and the thickness of LiNbO₃ is 0.25λ or less, the electromechanical coupling coefficient k² of an SH plate wave SH0 can be adjusted to 0.33 or more. The thickness of LiNbO₃ is preferably 0.2λ or less, because the electromechanical coupling coefficient k² can be adjusted to 0.40 or more. The thickness thereof is more preferably 0.17λ or less, because the electromechanical coupling coefficient k² can be adjusted to 0.43 or more.

As is clear from Figs. 2 to 5, in the case of using an SH plate wave propagating in LiNbO₃ substrates, when θ of the Euler angles of the LiNbO₃ substrates ranges from 92° to 138° and the thickness of the LiNbO₃ substrates is 0.25λ or less, the electromechanical coupling coefficient k² of the SH plate wave can be significantly increased. Incidentally, when the thickness of the LiNbO₃ substrate is excessively small, the elastic wave device, which includes the IDT electrodes 4, has a significantly reduced mechanical strength. In addition, it is difficult to assemble the elastic wave device 1 because of too small thickness. Thus, the thickness of the LiNbO₃ substrate needs to be 0.05λ or more.

Next, in the elastic wave device 1, the relationship between the thickness of the IDT electrodes 4 and bandwidth ratio has been investigated. Incidentally, the bandwidth ratio and the electromechanical coupling coefficient k² are in a proportional relationship.

IDT electrodes made of various metals were formed using LiNbO₃ substrates having Euler angles (0°, 120°, 0°) and a thickness of 0.1λ. In this structure, the IDT electrodes were varied in thickness and the fractional bandwidth Δf/f was determined. Incidentally, Δf is the difference between the antiresonant frequency fa and the resonant frequency f. That is, Δf equals fa minus f.

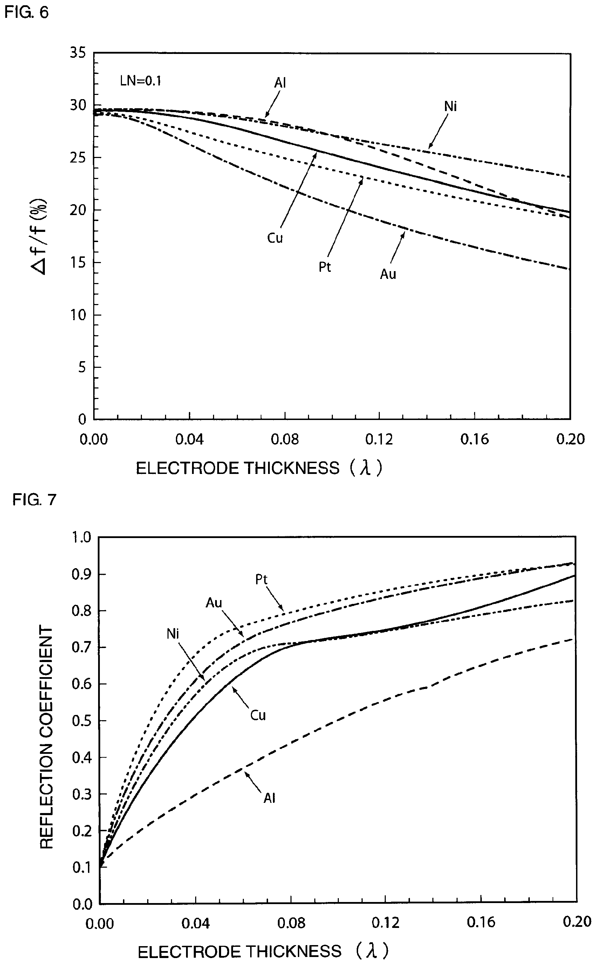

As is clear from Fig. 6, even when the IDT electrodes are made of Al, Ni, Cu, Pt, or Au, the fractional bandwidth Δf/f tends to decrease with the increase in thickness of the IDT electrodes.

Fig. 7 is a graph showing the relationship between the thickness of IDT electrodes and reflection coefficient in the above structure. It is clear from Fig. 7 that even when being made of any metal, the reflection coefficient increases with the increase in thickness of the IDT electrodes.

From results shown in Figs. 6 and 7, it is clear that when the thickness of the IDT electrodes is within a range shown in Table 5 below, the fractional bandwidth can be increased and the reflection coefficient can be increased to 0.1 or more.

Herein, for metals making up IDT electrodes, metals shown in Table 1 are major components. A metal different from the metals shown in Table 1 may be deposited but this is not a subject of the present invention.

Even when IDT electrodes are made of a metal other than the metals shown in Table 1, that is, a metal having a density between 2.699 × 10³ kg/m³, which is the density of Al, and 21.45 × 10³ kg/m³, which is the density of Pt, characteristics similar to characteristics shown in Figs. 6 and 7 can be obtained. In particular, the IDT electrodes are preferably made of a metal having a density between 2.699 × 10³ kg/m³, which is the density of Al, and 8.93 × 10³ kg/m³, which is the density of Cu.

**[Table 5]**

| | Δf/f: 25% or more | Δf/f: 27% or more | Δf/f: 29% or more |
|---|---|---|---|
| | Thickness of IDT electrode | Thickness of IDT electrode | Thickness of IDT electrode |
| Pt | More than 0 to 0.083λ or less | More than 0 to 0.05λ or less | More than 0 to 0.02λ or less |
| Au | More than 0 to 0.055λ or less | 0.035λ or less | 0.015λ or less |
| Cu | More than 0 to 0.11λ or less | 0.073λ or less | 0.04λ or less |
| Ni | More than 0 to 0.16λ or less | 0.105λ or less | 0.055λ or less |
| Al | More than 0 to 0.135λ or less | 0.105λ or less | 0.065λ or less |

The thickness of the IDT electrodes is within a range specified in the leftmost column of Table 5, because the fractional bandwidth can be adjusted to 25% or more. The thickness of the IDT electrodes is preferably within a range specified in the second column from the left, because the fractional bandwidth can be adjusted to 27% or more. The thickness of the IDT electrodes is more preferably within a range specified in the rightmost column of Table 5, because the fractional bandwidth can be increased to 29% or more.

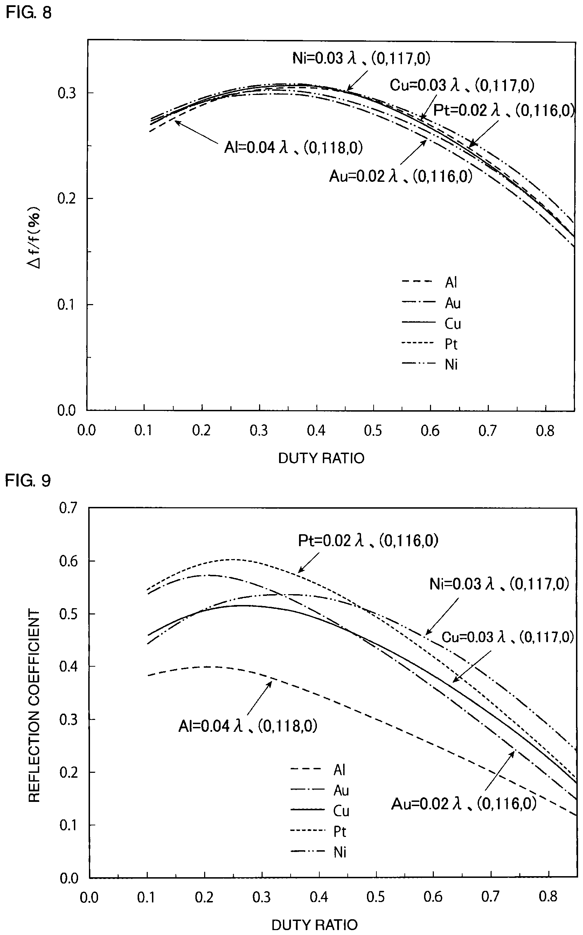

Next, IDT electrodes made of various metals were provided on LiNbO₃ substrates having Euler angles (0°, 116° to 118°, 0°) and a thickness of 0.1λ so as to have a thickness of 0.02λ to 0.04λ. Note that the duty ratio of the IDT electrodes was varied. Fig. 8 shows the relationship between the duty ratio of the IDT electrodes and the fractional bandwidth. Fig. 9 shows the relationship between the duty ratio and reflection coefficient of the IDT electrodes.

As is clear from Fig. 8, in the case of using any metal, when the duty ratio is 0.85 or less, the fractional bandwidth increases as the duty ratio increases from 0.1. However, the fractional bandwidth tends to gradually decrease as the duty ratio exceeds 0.4. Likewise, the reflection coefficient increases as the duty ratio increases from 0.1. The reflection coefficient tends to significantly decrease as the duty ratio exceeds 0.7. When the Euler angles are (0°, 92° to 138°, 0°), the relationship between the duty ratio and the fractional bandwidth Δf/f is on the same trend.

From results shown in Figs. 8 and 9, it is clear that in the case where electrodes made of each metal are used, the fractional bandwidth Δf/f can be increased and a sufficient reflection coefficient can be obtained in such a way that the duty ratio of the IDT electrodes is adjusted within a range shown in Table 6 below.

Herein, for metals making up IDT electrodes, the metals shown in Table 1 are major components. A metal different from the metals shown in Table 1 may be deposited but this is not a subject of the present invention.

Even when IDT electrodes are made of a metal other than the metals shown in Table 1, that is, a metal having a density between 2.699 × 10³ kg/m³, which is the density of Al, and 21.45 × 10³ kg/m³, which is the density of Pt, characteristics similar to characteristics shown in Figs. 8 and 9 can be obtained. In particular, the IDT electrodes are preferably made of a metal having a density between 2.699 × 10³ kg/m³, which is the density of Al, and 8.93 × 10³ kg/m³, which is the density of Cu.

**[Table 6]**

| | Δf/f: 26% or more | Δf/f: 27% or more | Δf/f: 30% or more |
|---|---|---|---|
| | Duty ratio | Duty ratio | Duty ratio |
| Pt | 0.105 to 0.62 | 0.11 to 0.58 | 0.22 to 0.43 |
| Au | 0.105 to 0.585 | 0.11 to 0.55 | 0.25 to 0.40 |
| Cu | 0.11 to 0.645 | 0.12 to 0.62 | 0.22 to 0.46 |
| Ni | 0.11 to 0.655 | 0.12 to 0.63 | 0.22 to 0.49 |
| Al | 0.115 to 0.63 | 0.13 to 0.60 | 0.25 to 0.47 |

The duty ratio of the IDT electrodes is preferably within a range specified in the leftmost column of Table 6, because the fractional bandwidth Δf/f can be adjusted to 26% or more. The duty ratio of the IDT electrodes is more preferably within a range specified in the second column from the left of Table 6, because the fractional bandwidth can be adjusted to 27% or more. The duty ratio of the IDT electrodes is further more preferably within a range specified in the rightmost column of Table 6, because the fractional bandwidth can be significantly increased to 30% or more.

In the above-described embodiment, the support 2 used has the through-hole 2a. A support substrate with an upper surface having a recessed portion facing a region provided with IDT electrodes may be used instead of the support 2.

That is, the following structure can be used: an appropriate structure in which a portion of a LiNbO₃ substrate that is provided with IDT electrodes can be mechanically freed.

The electrode structure of an elastic wave device is not limited to the one port-type elastic wave resonator shown in Fig. 1(b). An appropriate electrode structure can be used depending on a resonator or filter making use of an elastic wave.

### Reference Signs List

- 1: Elastic wave device
- 2: Support
- 2a: Through-hole
- 3: LiNbO₃ substrate
- 4: IDT electrodes
- 5, 6: Reflectors
- 21: Elastic wave device
- 22: IDT electrodes

## Claims

1. An elastic wave device (1) making use of a shear-horizontal plate wave propagating in LiNbO₃ substrates, comprising:
a LiNbO₃ substrate (3);
IDT electrodes (4) placed on at least one surface of the LiNbO₃ substrate (3); and
a support (2) on which the LiNbO₃ substrate (3) is placed such that the support (2) is located outside a region provided with the IDT electrodes (4) and supports the LiNbO₃ substrate (3),
wherein θ of the Euler angles (0°, θ, 0°) of the LiNbO₃ substrate (3) ranges from 92° to 138° and the thickness of the LiNbO₃ substrate ranges from 0.05λ to 0.25λ, where λ is a wavelength of the shear-horizontal plate wave determined by a pitch of electrode fingers of the IDT electrodes (4); and wherein the IDT electrodes (4) are made of a metal containing one of metals shown in Table 1 below as a major component and have a thickness within a range specified in Table 1 depending on the type of the metal:
**[Table 1]**
| | Thickness of IDT electrode |
|---|---|
| Pt | More than 0 to 0.083λ or less |
| Au | More than 0 to 0.055λ or less |
| Cu | More than 0 to 0.11λ or less |
| Ni | More than 0 to 0.16λ or less |
| Al | More than 0 to 0.135λ or less |

2. The elastic wave device (1) according to Claim 1, wherein the IDT electrodes (4) made of the metal containing one of metals shown in Table 2 below as a major component have a duty ratio within a range specified in Table 2 depending on the type of the metal:
**[Table 2]**
| | Duty ratio |
|---|---|
| Pt | 0.105 to 0.62 |
| Au | 0.105 to 0.585 |
| Cu | 0.11 to 0.645 |
| Ni | 0.11 to 0.655 |
| Al | 0.115 to 0.63 |

3. The elastic wave device (1/21) according to Claim 1 or 2, wherein the support (2) is a support substrate having a through-hole (2a) facing a region provided with the IDT electrodes (4/4,22).

4. The elastic wave device (1/21) according to any one of Claims 1 to 3, wherein the IDT electrodes (4/4,22) are made of a metal containing a metal having a density between 2.699 × 10³ kg/m³ to 8.93 × 10³ kg/m³ as a major component.

## Patentansprüche

1. Vorrichtung (1) für elastische Wellen, die eine Plattenwelle in horizontaler Schermode verwendet, die sich in LiNbO₃-Substraten ausbreitet, umfassend:
ein LiNbO₃-Substrat (3),
IDT-Elektroden (4), die auf mindestens einer Fläche des LiNbO₃-Substrats (3) angeordnet sind, und
einen Träger (2), auf dem das LiNbO₃-Substrat (3) so angeordnet ist, dass sich der Träger (2) außerhalb einer mit den IDT-Elektroden (4) versehenen Region befindet und das LiNbO₃-Substrat (3) trägt,
wobei θ der Euler-Winkel (0°, θ, 0°) des LiNbO₃-Substrats (3) von 92° bis 138° reicht und die Dicke des LiNbO₃-Substrats von 0,05 λ bis 0,25 λ reicht, wobei λ eine Wellenlänge der Plattenwelle in horizontaler Schermode ist, die durch einen Mittenabstand der Elektrodenfinger der IDT-Elektroden (4) bestimmt wird, und
wobei die IDT-Elektroden (4) aus einem Metall hergestellt sind, das eines der in Tabelle 1 unten angeführten Metalle als eine Hauptkomponente enthält, und eine Dicke innerhalb eines in Tabelle 1 angegebenen Bereichs in Abhängigkeit von der Art des Metalls aufweisen:
**Tabelle 1]**
| | Dicke der IDT-Elektrode |
|---|---|
| Pt | mehr als 0 bis 0,083 λ oder weniger |
| Au | mehr als 0 bis 0,055 λ oder weniger |
| Cu | mehr als 0 bis 0,11 λ oder weniger |
| Ni | mehr als 0 bis 0,16 λ oder weniger |
| Al | mehr als 0 bis 0,135 λ oder weniger |

2. Vorrichtung (1) für elastische Wellen nach Anspruch 1, wobei
die IDT-Elektroden (4), die aus dem Metall hergestellt sind, das eines der in Tabelle 2 unten angeführten Metalle als Hauptkomponente enthält, ein Metallisierungsverhältnis innerhalb eines in Tabelle 2 angegebenen Bereichs in Abhängigkeit von der Art des Metalls aufweisen:
**[Tabelle 2]**
| | Metallisierungsverhältnis |
|---|---|
| Pt | 0,105 bis 0,62 |
| Au | 0,105 bis 0,585 |
| Cu | 0,11 bis 0,645 |
| Ni | 0,11 bis 0,655 |
| Al | 0,115 bis 0,63 |

3. Vorrichtung (1/21) für elastische Wellen nach Anspruch 1 oder 2, wobei
der Träger (2) ein Trägersubstrat ist, das ein Durchgangsloch (2a) aufweist, das einer mit den IDT-Elektroden (4/4, 22) versehenen Region zugewandt ist.

4. Vorrichtung (1/21) für elastische Wellen nach einem der Ansprüche 1 bis 3, wobei
die IDT-Elektroden (4/4, 22) aus einem Metall hergestellt sind, das ein Metall enthält, das eine Dichte zwischen 2,699 × 10³ kg/m³ und 8,93 × 10³ kg/m³ als eine Hauptkomponente aufweist.

## Revendications

1. Dispositif à onde élastique (1) utilisant une onde de plaque horizontale de cisaillement se propageant dans des substrats de LiNbO₃, comprenant :
un substrat de LiNbO₃ (3) ;
des électrodes IDT (4) placées sur au moins une surface du substrat de LiNbO₃ (3) ; et
un support (2) sur lequel est placé le substrat de LiNbO₃ (3) de telle sorte que le support (2) se trouve à l'extérieur d'une région pourvue des électrodes IDT (4) et supporte le substrat de LiNbO₃ (3),
dans lequel θ des angles d'Euler (0°, θ, 0°) du substrat de LiNbO₃ (3) va de 92° à 138° et l'épaisseur du substrat de LiNbO₃ va de 0,05 λ à 0,25 λ, où λ est une longueur d'onde de l'onde de plaque horizontale de cisaillement déterminée par un pas de doigts d'électrode des électrodes IDT (4) ; et dans lequel les électrodes IDT (4) sont constituées d'un métal contenant un des métaux indiqués dans le tableau 1 ci-après en tant que composant principal et ont une épaisseur au sein d'une plage spécifiée dans le tableau 1 en fonction du type du métal :
**[Tableau 1]**
| | Epaisseur de l'électrode IDT |
|---|---|
| Pt | supérieure à 0 à inférieure ou égale à 0,083 λ |
| Au | supérieure à 0 à inférieure ou égale à 0,055 λ |
| Cu | supérieure à 0 à inférieure ou égale à 0,11 λ |
| Ni | supérieure à 0 à inférieure ou égale à 0,16 λ |
| Al | supérieure à 0 à inférieure ou égale à 0,135 λ |

2. Dispositif à onde élastique (1) selon la revendication 1, dans lequel les électrodes IDT (4) constituées du métal contenant un des métaux indiqués dans le tableau 2 ci-après en tant que composant principal ont un rapport cyclique au sein d'une plage spécifiée dans le tableau 2 en fonction du type du métal :
**[Tableau 2]**
| | Rapport cyclique |
|---|---|
| Pt | 0,105 à 0,62 |
| Au | 0,105 à 0,585 |
| Cu | 0,11 à 0,645 |
| Ni | 0,11 à 0,655 |
| Al | 0,115 à 0,63 |

3. Dispositif à onde élastique (1/21) selon la revendication 1 ou 2, dans lequel le support (2) est un substrat de support ayant un trou traversant (2a) faisant face à une région pourvue des électrodes IDT (4/4,22).

4. Dispositif à onde élastique (1/21) selon l'une quelconque des revendications 1 à 3, dans lequel les électrodes IDT (4/4,22) sont constituées d'un métal contenant un métal ayant une densité entre 2,699 x 10³ kg/m³ et 8,93 x 10³ kg/m³ en tant que composant principal.
